# EUROPEAN PATENT SPECIFICATION

(11) **EP 0 926 597 B1**
(45) Date of publication and mention of the grant of the patent: **07.05.2003**
(21) Application number: 97122560.2
(22) Date of filing: 19.12.1997
(51) Int. Cl.: G06F 11/26

(54) **Method and apparatus for performing fully visible tracing of an emulation**
Verfahren und Vorrichtung zur vollsichtbaren Ablaufverfolgung einer Emulation
Procédé et dispositif pour réaliser un traçage complètement visible d'une émulation

(43) Date of publication of application: 30.06.1999
(60) Divisional application: 02023902.6
(73) Proprietor: Mentor Graphics Corporation, Wilsonville, Oregon (US)
(72) Inventor: Barbier, Jean, 92320 Chatillon (FR); Lepape, Olivier, 75016 Paris (FR); Reblewski, Frederic, 91470 Les Molieres (FR)
(74) Representative: Patentanwälte Leinweber & Zimmermann

(56) References cited:
- EP-A- 0 411 904
- US-A- 5 321 828
- US-A- 5 680 583

## Description

### BACKGROUND OF THE INVENTION

### 1. Field of the Invention

The present invention relates to the field of emulation systems. More specifically, the present invention relates to methods and apparatus for performing tracing of an emulation.

### 2. Background Information

Emulation systems for emulating circuit design are known in the art. Typically, prior art emulation systems are formed using conventional general purpose field programmable gate arrays (FPGAs). A circuit design to be emulated is "realized" on the emulation system by compiling a "formal" description of the circuit design, and mapping the circuit design onto the logic elements (LEs) of the FPGAs.

Conventional general purpose FPGAs, as far as their applications to emulation systems are concerned, have at least three disadvantages. First of all, the states of signals at the nodes mapped inside the FPGAs are not observable, thus the term "hidden" nodes. Secondly, in order to be able to observe the states of signals at these "hidden" nodes, reconfiguration, and therefore extremely time consuming recompilation is required to bring these signals outside the FPGAs to a logic analyzer. Thirdly, a number of FPGA I/Os have to be consumed for bringing these signals to the outside logic analyzer. Furthermore, the additional signals to be routed further increase signal routing congestion. Finally, for timing sensitive applications, it is difficult to know whether the signals at these "hidden" nodes were read at precisely the correct time or not, if the signals are to be read in response to the occurrence of certain events, since the signals have to be brought out of the FPGAs before the read triggering events can be detected.

US-A-5 680 583 discloses various emulation systems including one which is based on the use of FPGAs. In this conventional FPGA-based emulation system, a trace system is connected to I/O pins of FPGAs whereby signals appearing at these I/O pins may be traced. This does not allow for changing the pin assignment as is necessary for free configurability in emulating different circuit designs. Moreover, signal state values of individual logic elements inside the FPGAs cannot be detected.

US-A-5 425 036 refers to FPGAs featuring a "read-back" function, in particular the XC4000 FPGA family, which is available commercially from Xilinx, Inc. in San Jose, Calif. The read-back function is described to permit a "snap shot" of the contents of all flip-flops to be taken at the start of each read-back call. The read-back data are made accessible for further processing at ports on the boundary of circuit boards which have a plurality of the FPGAs arranged thereon.

Thus it is an object of the present invention to have an emulation system and a methodology for operating therein for performing fully visible tracing of an emulation.

This is according to the invention attained by the features of independent claims 1 and 12.

According to the invention an improved emulation system and methodology for operating therein for performing fully visible tracing is constituted with a plurality of improved FPGAs having on-chip integrated facilities, distributively disposed on a plurality of circuit boards (For the purpose of this application, the terms circuit boards and logic boards are synonymous.) incorporated with the teachings of the present invention. In a specific embodiment, each FPGA's on-chip integrated debugging facilities include in particular, a scan register for outputting trace data for the LEs inside the FPGA, on a clock cycle by clock cycle basis, making the LEs fully visible from outside the FPGA, and comparison circuitry for generating trigger inputs for a number of system triggers in response to the detection of certain pre-stored data patterns.

Correspondingly, each circuit board is provided with a plurality of trace memory units, one per FPGA, for recording the trace data output by the FPGAs. Preferably summing circuitry, one per system trigger, for generating partial sums of the trigger inputs output by the FPGAs is provided. The on-board trace memory is designed to facilitate recordation of trace data with a deterministic locality topology. In other words, the relative memory location within a clock cycle of trace data where the output of a LE of a particular FPGA will be recorded is predeterminable. Each circuit board is also provided with an address counter for generating addresses for the on-board trace memory.

Additionally, a number of system triggers are provided to generate a number of trigger signals using the partial sums output by the on-board summing circuitry, and a system synchronization memory is provided for synchronously recording sync patterns to facilitate recording of trace data in the on-board trace memory in a "wrap around" manner. A system address counter is also provided for generating addresses for the system synchronization memory. The compilation/mapping software is also enhanced to generate a cross-reference file of cross reference records cross referencing the circuit elements of a circuit design to be emulated to the predeterminable memory locations wherein the trace data for the circuit elements are to be found.

During compilation/mapping, the cross reference file is generated and saved. Then, during operation, the on-board address counters and the system address counter are reset each time a reset signal is asserted, such as at the beginning of an emulation. Upon detection of a monitored event by a trigger, signal state values of the LEs of the various FPGAs are caused to be scanned out and stored into the on-board trace memory. At the same time, sync patterns are synchronously stored into the system sync memory. During post processing, the sync patterns are used to reconstitute the trace data of a "trace session", whereas the cross reference records are used to retrieve trace data of specific circuit elements.

### BRIEF DESCRIPTION OF DRAWINGS

The present invention will be described by way of exemplary embodiments, but not limitations, illustrated in the accompanying drawings in which like references denote similar elements, and in which:
**Figure 1** illustrates an exemplary emulation system incorporated with the teachings of the present invention;
**Figure 2** is a physical view of one embodiment of the emulator of **Fig. 1;**
**Figure 3** illustrates one embodiment of the logic board of **Fig. 2;**
**Figures 4a - 4b** illustrate one embodiment of the FPGA array of **Fig. 3;**
**Figure 5** illustrates one embodiment of the inter-FPGA crossbar network (stage 1) of **Fig. 3**;
**Figure 6** illustrates one embodiment of the on-board summing circuitry of **Fig. 3**;
**Figure 7** illustrates one embodiment of the on-board trace memory of **Fig. 3,** and system sync memory of **Fig. 8;**
**Figure 8** illustrates one embodiment of the backplane of **Fig. 2;**
**Figure 9** illustrates one embodiment of the inter-board crossbar network (stage 1) of **Fig. 8**;
**Figure 10** is an exemplary timing diagram illustrating the manner in which trace data of the LEs of a FPGA are caused to be output;
**Figure 11** illustrates one embodiment of the circuit design compilation/mapping software of **Fig. 1;** and
**Figure 12** illustrates one embodiment of the cross reference file of **Fig.** 11.

### DETAILED DESCRIPTION OF THE INVENTION

In the following description, for purposes of explanation, specific numbers, materials and configurations are set forth in order to provide a thorough understanding of the present invention. However, it will be apparent to one skilled in the art that the present invention may be practiced without the specific details. In other instances, well known features are omitted or simplified in order not to obscure the present invention.

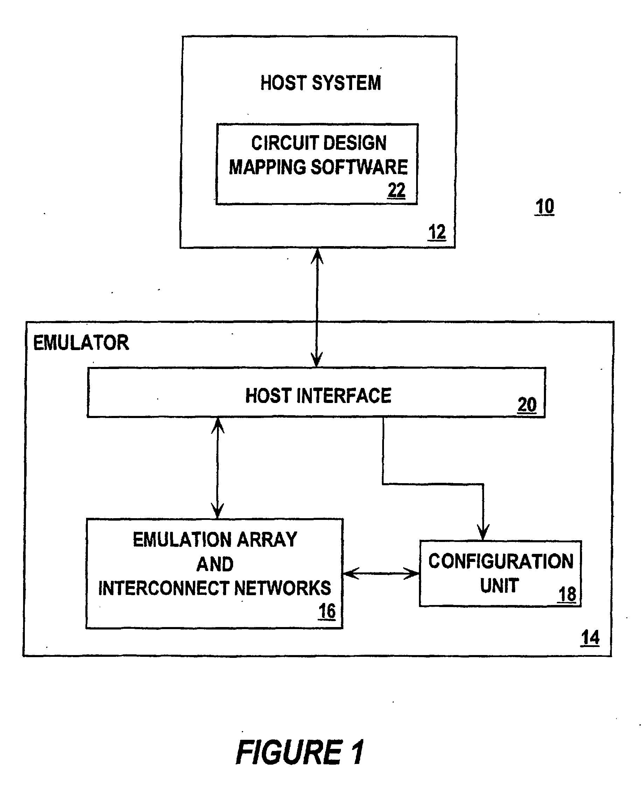

Referring now to **Figure 1**, an emulation system **10** incorporated with the teachings of the present invention is shown. As illustrated, emulation system **10** includes host system **12** and emulator **14**. Host system **12** includes in particular enhanced circuit design compilation/mapping software **22**. Circuit design compilation/mapping software **22** are stored in suitable storage medium (not shown) of host system **12**, and loaded into memory (not shown) of host system **12** for execution by one or more processors (not shown) of host system **12**. Except for the enhancement provided to circuit design compilation/mapping software **22**, host system **12** including circuit design compilation/mapping software **22** is intended to represent a broad category of host systems and their software found in conventional emulation systems, thus will not be otherwise further described.

Emulator **14** includes emulation array and interconnecting networks **16** incorporated with the teachings of the present invention, configuration unit **18** and host interface **20** coupled to each other as shown. Except for emulation array and interconnecting network **16**, configuration unit **18** and host interface **20** are also intended to represent a broad category of these elements found in conventional emulators, whose functions and constitutions are also well known, and therefore will not be further described either.

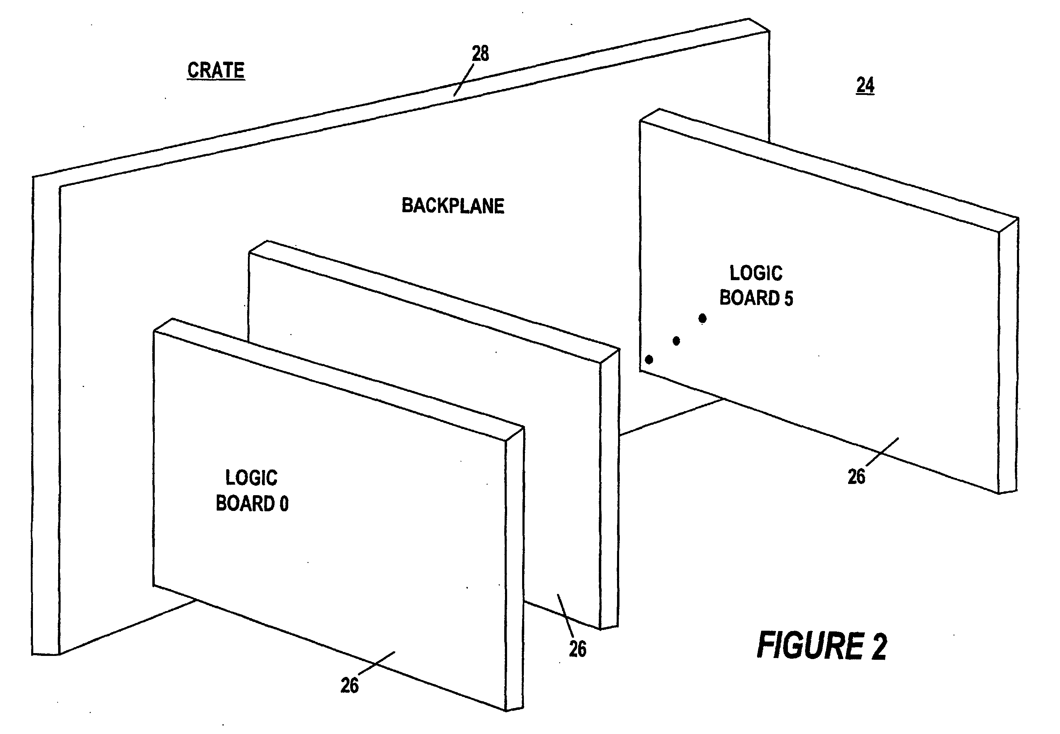

Referring now to **Figure 2,** wherein a physical view of one embodiment of emulation array and interconnect networks **16** is shown. For the illustrated embodiment, emulation array and interconnect networks **16** is distributively disposed on a plurality of logic boards **26.** Logic boards **26** are electrically connected to each other through backplane **28**. Together, logic boards **26** and backplane **28** are packaged in crate **24**. Before we proceed to describe logic boards 26 and backplane 28 in further detail, it should be noted that while for ease of explanation, the present invention is being described with a single crate embodiment, based on the description to follow, a person skilled in the art will appreciate that the present invention may be practiced in any number of form factors comprising any number of "crates" with each "crate" having any number of "logic boards" directly connected to each other or indirectly connected to each other via one or more "backplanes".

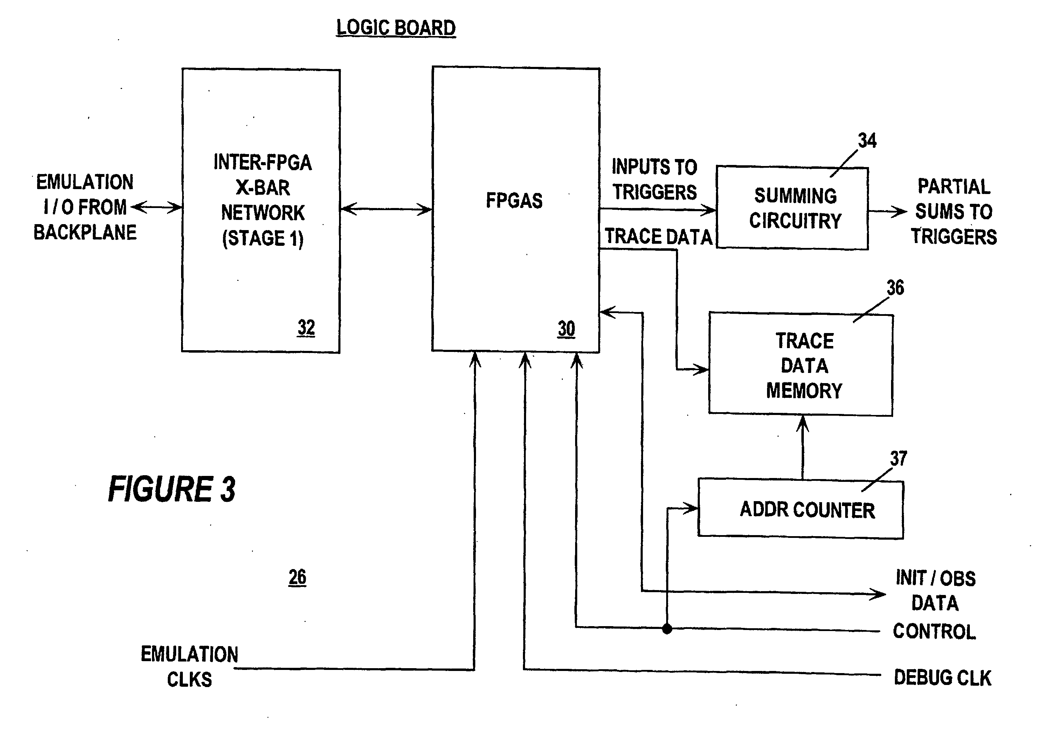

**Figure 3** illustrates one embodiment of logic board **26**. As shown, for the illustrated embodiment, each logic board **26** comprises a plurality of FPGA **30** for "realizing" the circuit elements of a circuit design. In other words, FPGAs **30** of emulation array **16** are distributively disposed on one or more logic boards 26. Additionally, each logic board **26** further comprises inter-FPGA crossbar (or x-bar) network (stage 1) **32** coupled to FPGAs **30** for interconnecting FPGAs **30** on the various logic boards **26** to each other and to host system **12**. Furthermore, logic board 26 comprises trace data memory **36**, and summing circuitry **34**, both coupled to FPGAs **30**, for capturing and storing fully visible L.E trace data of FPGAs **30** and generating partial sums for trigger inputs output by FPGA **30**. Logic board **26** is also provided with address counter **37** for generating addresses for trace data memory **36**.

In accordance to the present invention, each FPGA of FPGAs **30** is to include on-chip integrated debugging facilities. In particular, each FPGA is to include a first integrated debugging facility for outputting fully visible trace data of all its LEs, on a clock cycle by clock basis, and a second integrated debugging facility for outputting inputs for a plurality of system triggers. A particular example of a FPGA having such on-chip integrated debugging facilities is disclosed in copending European Patent Application No. 97 122 571, entitled "A field programmable gate array with integrated debugging facility", having common inventorship and applicant with the present invention, and filed contemporaneously with this application . Nevertheless, we will be briefly describe the FPGA disclosed in the copending application further below.

Inter-FPGA crossbar network (stage 1) **32** comprises a plurality of programmable electrical signal switching paths. Inter-FPGA crossbar network (stage 1) **32,** also functionally "doubles" as inter-board crossbar network (stage 0) for interconnecting logic boards **26**, to be described more fully below. A particular example of inter-FPGA cross network (stage 1) **32** will also be briefly described below.

On-board trace data memory **36** in accordance to the present invention facilitates capturing and storing trace data output by FPGAs **30**, i.e., signal state values of the LEs of FPGAs **30,** with a deterministic locality topology. In other words, the relative memory location within a clock cycle of trace data where the output of a LE of a particular FPGA is to be recorded is pre-determinable. Trace data memory 36 is advantageously placed on-board close to FPGAs **30** to ensure all signal state values of all LEs of a FPGA can be captured and stored within a clock cycle of an emulation clock, without having to slow down the emulation clock to accomplish the clock cycle by clock cycle objective (In many emulations, the option of "slowing down" the emulation clock is not even available, since the design is to be emulated in the target operating speed.). In the presently preferred embodiment, one trace data memory unit is provided for each FPGA. The trace data memory units **36** and the FPGAs **30** are correspondingly coupled to each other. Moreover, fast dual ported video random access memory (RAM) are used for trace data memory **36** to further facilitate achieving the objective of being able to capture and store the trace data of all LEs on a clock cycle by clock cycle basis.

On-board address counter **37** is provided for generating addresses for on-board trace memory **36**. On-board address counter **37** is incremented using the same scan clock employed for scanning out the trace data of all LEs of FPGAs **30**, on a clock cycle by clock cycle basis, to be more fully described below. While functionally, one "global" address counter is sufficient, however, one address counter **37** per logic board **26** is preferred, in order to eliminate having to route the trace memory addresses to each logic board **26**, thereby reducing the pin out requirements on each logic board **26**.

On-board summing circuitry **34** comprises a plurality of partial sum circuits. In the presently preferred embodiment, one summing circuit is provided for each system trigger, and all FPGAs **30** are coupled to each of the summing circuits **34**.

Trace data memory **36** and summing circuitry **34** will be described in more detail below with references to the additional figures. However, we will first briefly describe the FPGA and the relevant aspect of interconnecting FPGAs.

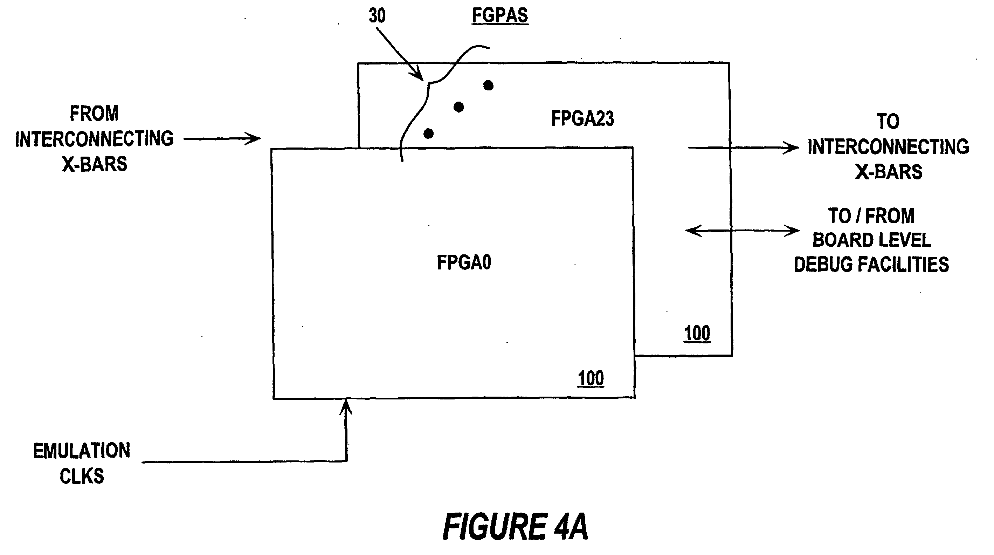

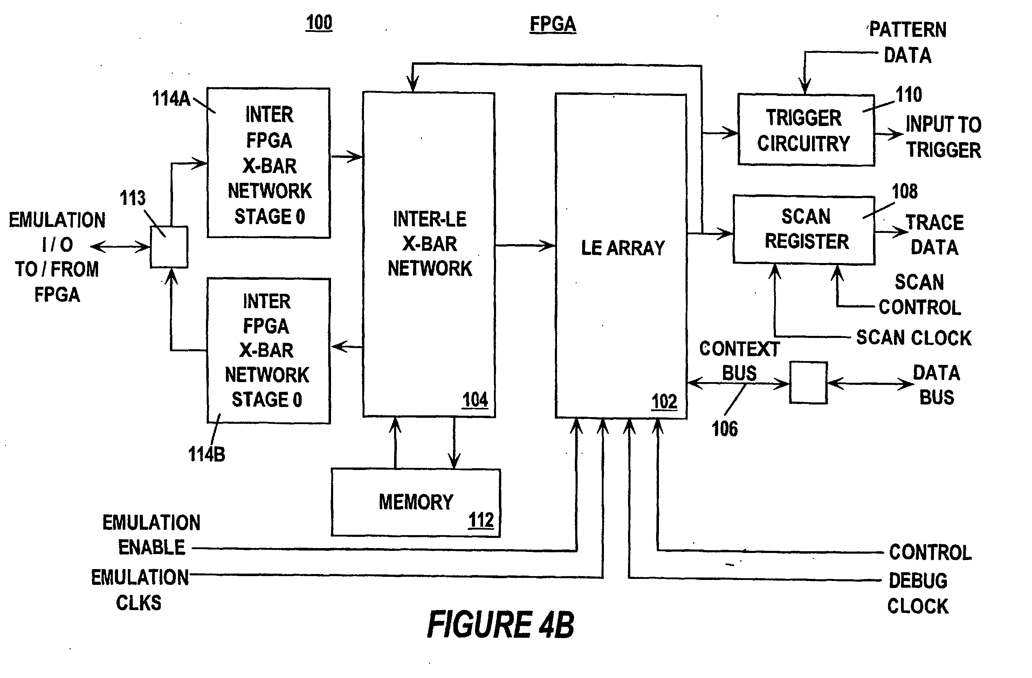

**Figures 4a-4b** illustrate one embodiment of FPGAs **30** disclosed in the copending application. As shown, for the illustrated embodiment, FPGAs **30** comprise 24 FPGAs with on-chip integrated debugging facilities **100**. FPGA **100** comprises an array **102** of enhanced LEs, which are used to "realize" various elements of circuit designs. Additionally, FPGA **100** further includes context bus **106,** scan register **108** and trigger circuitry **110**, coupled to the enhanced LEs as shown. Context bus **106** is used for inputting and outputting values to and from the LEs. Scan register **108** is used to output trace data of all LEs of a FPGA in one clock cycle of an emulation clock, whereas trigger circuitry **110** is used to generating a number of trigger inputs in response to the detection of a number of stored data patterns.

For the illustrated embodiment, FPGA **100** further includes memory **112** to facilitate usage of FPGA **100** for emulating circuit designs with memory. Pins **113** of FPGA **100** can be preconfigured for either input or output. FPGA **100** also includes inter-LE crossbar network **104** for interconnecting the LEs **102,** memory **112,** and I/O pins 113, as shown. Finally, FPGA 100 also include the inter-FPGA crossbar network (stage 0) **114** for inter-connecting FPGA **100** to other FPGAs. Inter-FPGA cross-bar network (stage 0) **114** at the chip-level "mates" with inter-FPGA cross-bar network (stage 1) **32** at the board level.

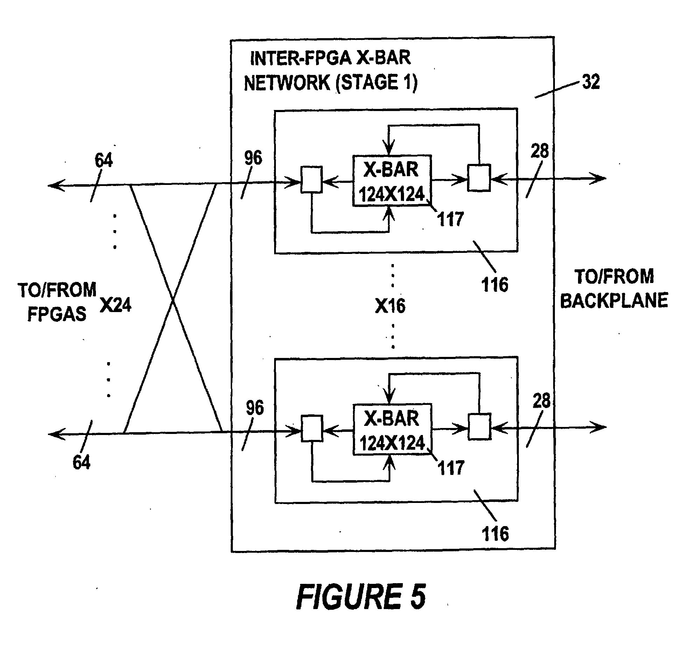

**Figure 5** illustrates one embodiment of inter-FPGA crossbar network (stage 1) **32** disclosed in the above identified copending application. As shown, for the illustrated embodiment, inter-FPGA crossbar network (stage 1) **32** comprises **16** routing chips **116** for coupling 64 I/O signals from each of 24 FPGAs **30** to the next stage of a Claus network for interconnecting the FPGAs to each other. In other words, full cross switching between the 64 I/O pins of each FPGA and the 448 I/O pins of logic board **26** is provided. Each of routing chips **116** comprises a 124 x 124 crossbar **117** to facilitate routing of 96 signals to/from FPGA **30** and 28 signal to/from backplane **28**.

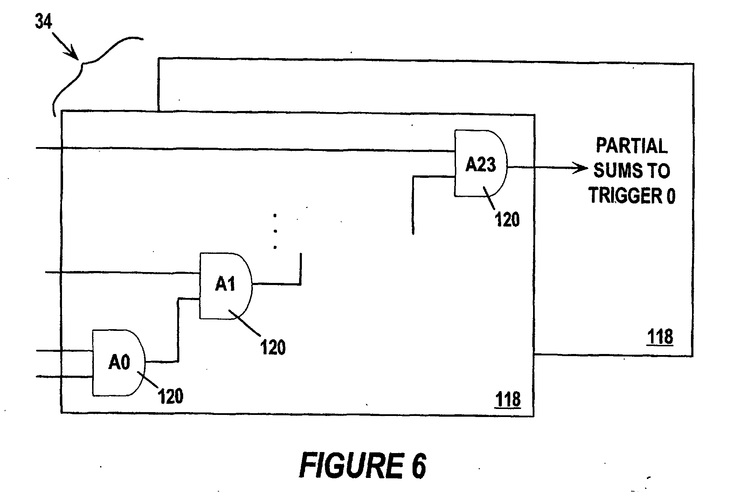

Referring now to **Figure 6**, wherein one embodiment of on-board summing circuitry **34** is illustrated. As shown, for the illustrated embodiment, on-board summing circuitry **34** comprises four sets of AND gates **118**. In other words, for the illustrated embodiment, partial sum inputs are generated for 4 system triggers. Each set **118** comprises 24 AND gates, serially coupled to each other and corresponding coupled to 24 FPGAs **30**. Each set **118** receives the trigger inputs output by the corresponding FPGAs **30** and in response, the received inputs are incrementally aggregated to generate a partial sum input for all 24 FPGAs **30** for a system trigger. The system trigger may be used for a variety of purposes, including in particular, the starting of trace data collection.

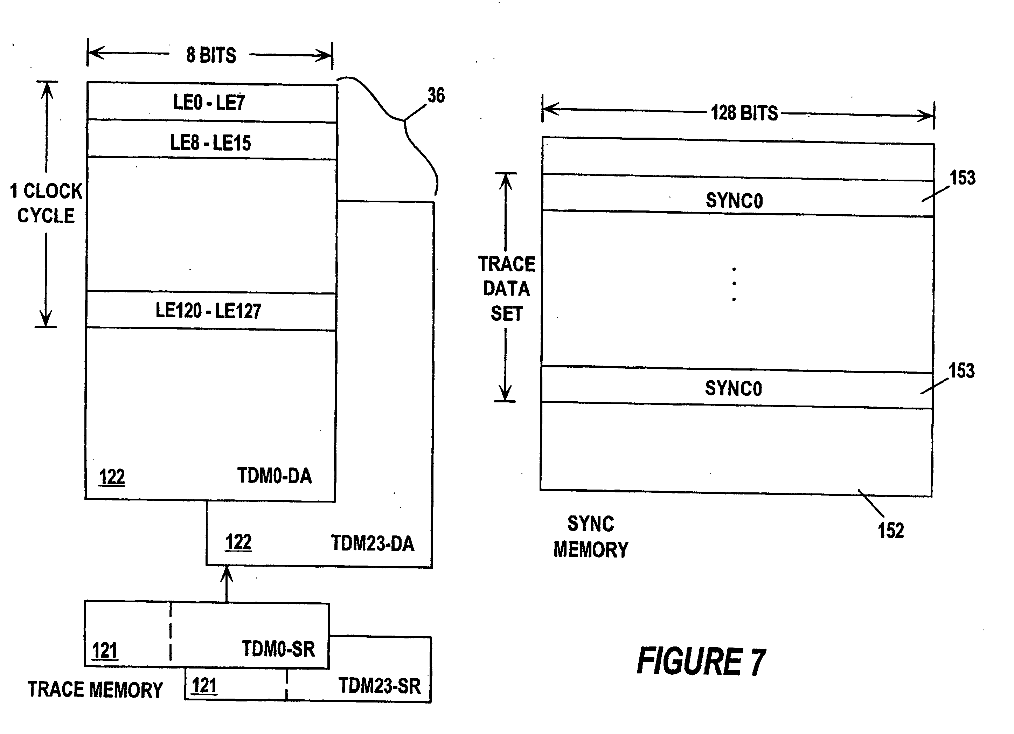

Referring now to **Figure 7**, wherein one embodiment of on-board trace memory **36** is illustrated. **Figure 7** also illustrates system sync memory **152** whose description will be deferred until backplane **28** has been described. As shown, for the illustrated embodiment, trace memory **36** comprises **24** memory units i.e. one per FPGA of FPGAs **30**. As described earlier, each memory unit is preferably implemented using fast dual-port video RAM comprising a RAM array portion **122**, and a shift register portion **121.** Preferably, each half of shift register **121** can be operated on independently of the other half, allowing the two halves to be independently loaded into the corresponding RAM array **122** as soon as it is filled, without having to wait for the filling of the other half to be completed. For the illustrated embodiment, on-board trace memory unit **122** is 8-bit wide. Thus, for an embodiment wherein the FPGA comprises 128 LEs, 16 bytes (16x8=128) are used to store the trace data output by a FPGA per clock cycle. Therefore, the precise memory location where the trace data of a LE will be written in trace memory **36** is predeterminable. As a result, once the decision is made as to the mapping of a particular circuit element of a circuit design to be emulated, the relative memory location within a clock cycle of trace data where the output of the particular circuit will be written is known.

Under the presently preferred embodiment, trace data are stored in trace memory **36** from "top" to the "bottom" Once the "bottom" of trace memory **36** is reached, storage of trace data starts from the "top" again. In other words, trace memory **36** is accessed as a "wrap around" buffer. As will be described in more detail below, sync patterns synchronously stored in a system sync memory **152** are used to reconstitute the trace data of a "trace session" during post processing.

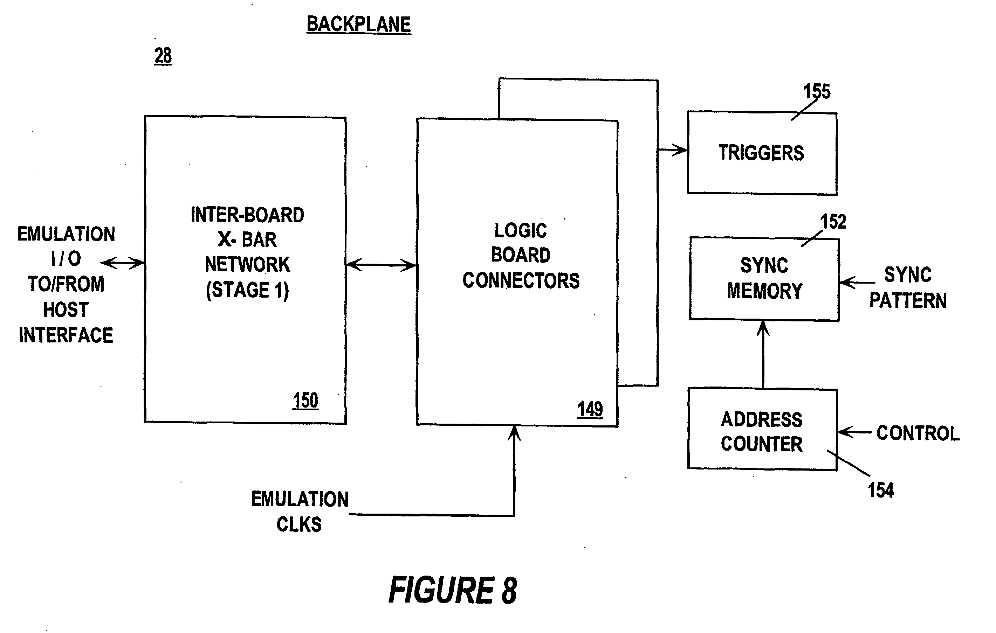

Having now described the major components at the board level. We now proceed to describe how the boards are electrically coupled to each together. Recall from **Fig. 2** that multiple logic boards **26** are physically and electrically coupled to backplane **28** to form crate **24**. **Figure 8** illustrates one embodiment of backplane **28.** In addition to logic board connectors **149** for receiving logic boards **26**, backplane **28** further comprises inter-board crossbar network (stage 1) **150** for electrically interconnecting logic boards **26**. Functionally, inter-board crossbar network (stage 1) **150** can also be considered as inter-FPGA crossbar network (stage 2). (For multi-crate embodiments, it also "doubles" as inter-crate crossbar network stage 0.)

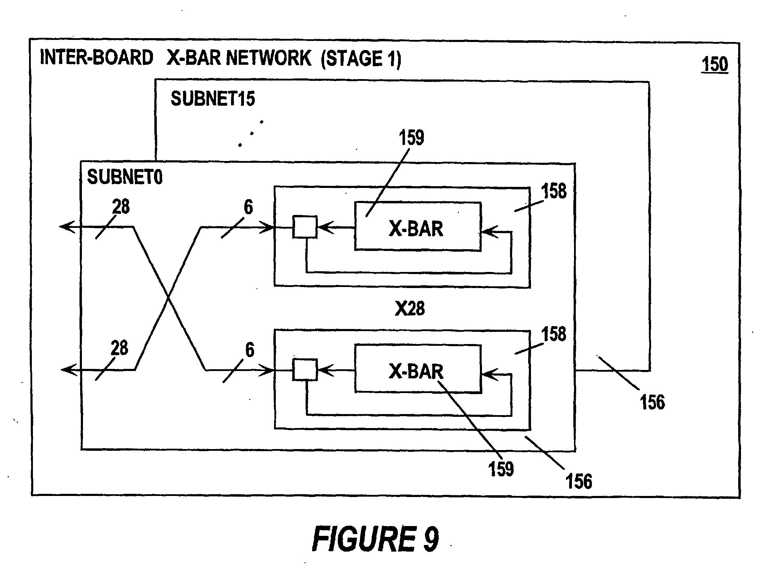

**Figure 9** illustrates one embodiment of inter-board crossbar network (stage 1) **150.** As shown, for the illustrated embodiment, inter-board crossbar network (stage 1) **150** comprises 16 subnets, subnet0 through subnet15 **156**. Each subnet **156** comprises 28 routing chips **156** for interconnecting 6 sets of 28 signals output by FPGAs **30** at the board level in a "butterfly" manner, one set per logic board **26.** Each routing chips **156** comprises a 6 x 6 crossbar **159** for providing routing of 6 signals to/from logic boards **26** (Some or all of routing chips **158** may be combined together, in particular, for "larger" embodiments.). In other words, only the outputs of the correspondingly disposed routing chips **116** in inter-FPGA crossbar network (stage 1) **32** on various logic boards **26** are interconnected together. For examples, the "first" routing chip **116** in inter-FPGA crossbar network (stage 1) **32** on the six logic boards **26** are interconnected together, the "second" routing chip **116** in inter-FPGA crossbar network (stage 1) **32** on the six logic boards **26** are interconnected together, and so forth.

Referring back to **Figure 8,** backplane **28** further comprises a number of system triggers **155,** system sync memory **152,** and system address counter **154**. Each system trigger **155** receives a partial sum output from each of logic boards **26,** and in response, triggers a global signal if the at least one of the received partial sums is in a desired state. As described earlier, sync memory **152** is used to synchronously store sync patterns as trace data are output from FPGAs **30** and stored into on-board trace memory **36**. System address counter **154** is used to generate addresses for sync memory **152**. Address counter **154** is incremented proportionally using the same scan clock for scanning out trace data and incrementing on-board address counters **37** described earlier. For example, in one embodiment, system address counter **154** is incremented once for each clock cycle, while on-board address counters **37** are incremented16 times for each clock cycle. While triggers **155**, sync memory **152** and address counter **154** are being described as disposed on backplane **28**, as will be appreciated by those skilled in the art, they may be disposed in a number of alternative locations, for example, a common control or service board.

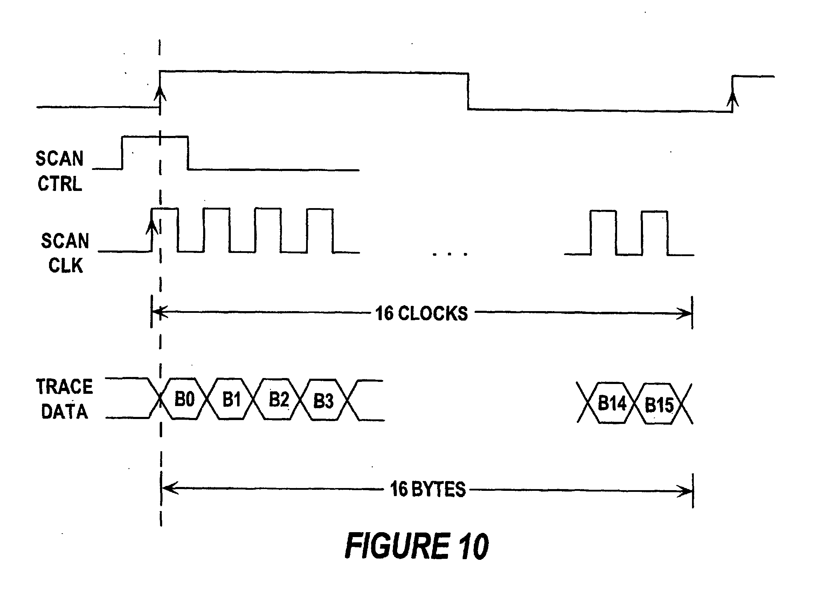

Before describing system sync memory **152** more fully, refer now briefly to **Figure 10**, wherein an exemplary timing diagram for causing trace data to be scanned out of LE array **102** of FPGA **100** is shown. As shown, at the rising edge of the current operating emulation clock, a scan control signal and a number of scan clock pulses are provided by host system **10** to scan register **108** causing scan register **108** to serially scan out the current values of the LEs of LE array **102.** If trace data are collected in response to the detection of certain events, the scan control signal and scan clock pulses are provided in response to the trigger signals generated as a result of the detection of prestored data patterns representing the events. The number of clock pulses to be provided are determined by the number of internal elements of scan register **108.** In an embodiment where scan register **108** comprises 16 sets of 8 flip-flops with each set responsible for 8 LEs, 16 clock signals are provided as shown. The required clock pulses are provided in-between two rising edges of the operating emulation clock, to ensure all LE trace data are scanned out within one clock cycle, thereby allowing fully visible LE trace data to be captured in a clock cycle by clock cycle basis. In response, as illustrated, for the 16 flip-flop set embodiment, 16 bytes of trace data are written into the trace memory unit of trace memory **36** corresponding to the particular FPGA **100.**

Referring now to **Figure 7** again, as the trace data are scanned out of FPGAs **30,** the trace data are shifted into the corresponding shift registers **121** of trace memory **36.** Whenever the left or right halves of shift registers **121** are filled, the stored trace data are stored into the corresponding memory locations of trace memory **36** denoted by on-board address counter **37.** Concurrently, a sync pattern **153** is stored into a corresponding memory location of system sync memory **152** denoted by system address counter **154.** In one embodiment, sync pattern **153** is the same size as one clock cycle for trace data, e.g. 128 bits for the 128 LE FPGA embodiment. The same sync pattern is used for all trace data collected in a "trace session". Thus, during post processing, starting at memory locations in all on-board trace memory **36** corresponding to where address counter **154** stopped, the trace data of a "trace session" can be reconstituted by reading proportionally "backward" in all on-board trace memory **36,** as long as corresponding "backward" reading of sync patterns **153** stored in sync memory **152** remain unchanged.

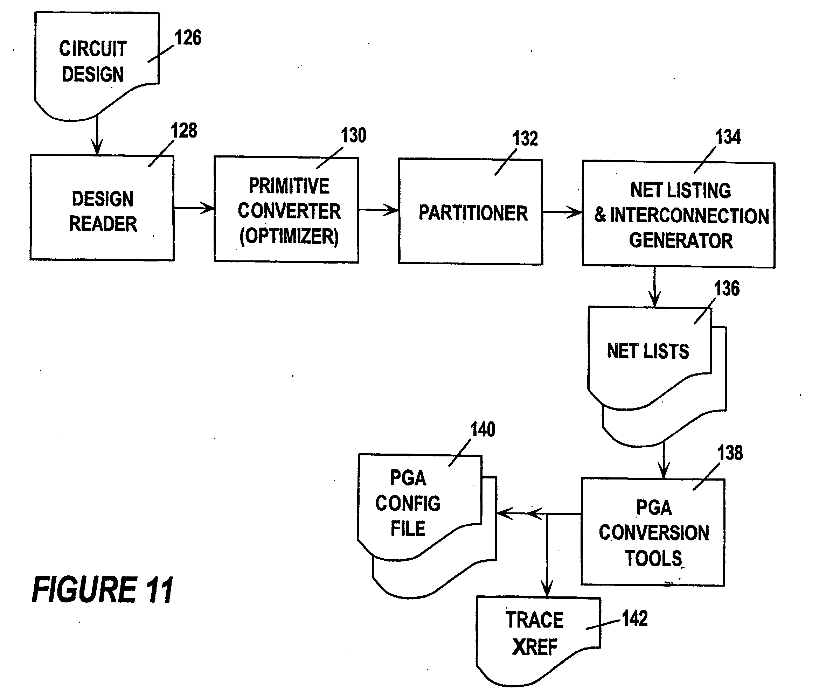

Having now described the operating method for collecting the fully visible trace data, and the manner in which the trace data of a "trace session" can be reconstituted, we now proceed to describe how the trace data can be correlated with the various circuit elements of the circuit design being emulated. Recall from earlier description, host system **12** includes circuit design compilation/mapping software (see **Fig. 1)** for compiling and mapping the circuit design to the LEs of FPGAs **30,** and the memory locations where the state values of the LEs will be written are predeterminable (see **Fig. 7**). **Figure 11** illustrates one embodiment of circuit design compilation/mapping software **22** enhanced to leverage the deterministic characteristic of the LE trace data storage locations, As shown, circuit design compilation/mapping software **22** comprises design reader **128,** primitive converter **130,** partitioner **132,** and net listing and interconnection generator **134** for reading, interpreting, optimizing, and partitioning circuit design **124** into net lists **136.** Circuit design compilation/mapping software **22** further comprises PGA configuration tools **138** for converting net lists **136** into PGA conversion files **140,** which are then used to configure emulator **14** to "realize" circuit design **126** on emulator **14.** Additionally, in accordance to the present invention, PGA conversion tools **138** are enhanced to also generate cross reference file **142** for cross referencing circuit elements of circuit design **126** to memory locations of trace memory **36.**

Except for the generation of cross reference file **142,** design reader **128,** primitive converter **130** etc. of circuit design compilation/mapping software **22** are intended to represent a broad category of these software tools found in conventional emulation systems, thus will not be further described.

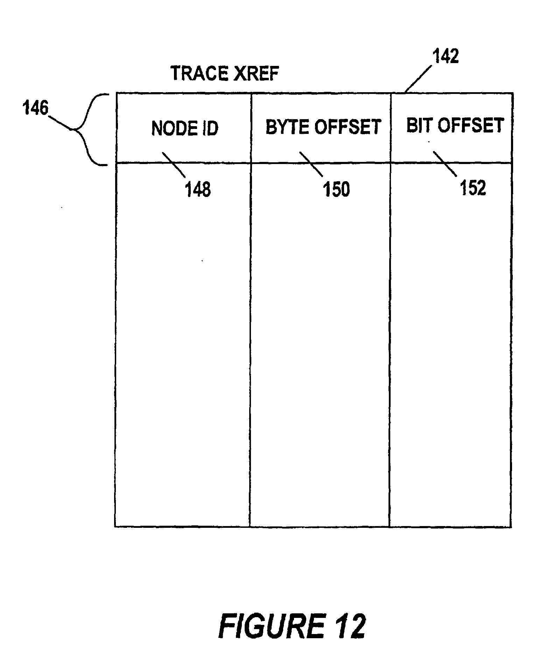

**Figure 12** illustrates one embodiment of cross reference file **142.** As shown, cross reference file **142** comprises cross reference records **146** for circuit elements of circuit design **126.** Each cross reference record **146** comprises a node identifier **148** identifying the circuit element, a byte offset **150** identifying the offset location into each group of trace data (for a clock cycle) where the trace data for the particular circuit element is to be found, and a bit offset **152** identifying the offset location into the identified byte position where the trace data for the particular circuit element is located.

Thus, when an emulator system is equipped with FPGA having on-chip integrated facilities, which in turn are complemented with trace memory with the above described deterministic characteristics, fully visible tracing may be performed employing the cross references and sync patterns as described above. Therefore, a method and apparatus for performing fully visible tracing of an emulation has been described.

While the method and apparatus of the present invention has been described in terms of the above illustrated embodiments, those skilled in the art will recognize that the invention is not limited to the embodiments described. The present invention can be practiced with modification and alteration within the scope of the appended claims. The description is thus to be regarded as illustrative instead of restrictive on the present invention.

## Claims

1. An apparatus comprising:
a plurality of field programmable gate arrays (FPGAs) for emulating at least a subset of a circuit design, said plurality of FPGAs (30) being distributively disposed on one or more interconnected logic boards (26), each FPGA (30) being a single integrated circuit comprising a plurality of logic elements (LEs) (102) for realizing circuit elements of the at least a subset of the circuit design and an on-chip integrated output facility (108) for outputting as trace data signal state values of all LEs (102) on a clock cycle by clock cycle basis of an emulation clock; and
trace memory coupled to the FPGAs (30) comprising a plurality of memory locations for capturing and storing the LE signal state values output in a deterministic locality topology, under which the relative memory location within a clock cycle of trace data where the signal state value of a circuit element is stored is predeterminable,
wherein said trace memory is placed on-board close to said FPGAs (30) and comprises a plurality of memory units (36), one for each FPGA (30), said memory units (36) and said FPGAs (30) being correspondingly coupled to each other.

2. The apparatus as set forth in claim 1, wherein each memory unit (36) comprises memory locations for storing N clock cycles of LE signal state values, and the signal state value of a LE (102) is stored in a predetermined fixed offset with respect to each clock cycle into each block of memory locations used for storing a clock cycle of LE signal state values.

3. The apparatus as set forth in anyone of claims 1 or 2, wherein the apparatus further comprises an address counter (37) coupled to the trace memory (36) for generating addresses for the trace memory (36) in a manner coordinated with the outputting of the LE signal state values.

4. The apparatus as set forth in anyone of claims 1 to 3, wherein
each FPGA (30) further comprises an on-chip trigger circuit (110) for outputting at least one trigger input in response to the detection of a stored data pattern of the LE signal state values; and
the apparatus further comprises at least one summing circuit (34) coupled to the FPGAs (30) for generating a partial sum of the at least one trigger input.

5. The apparatus as set forth in claim 4, wherein
the FPGAs (30) are distributively disposed in a plurality of logic boards (26),
the summing circuit (34) comprises a plurality of at least one partial sum circuit (118) distributively disposed on the logic boards (26) and coupled to the FPGAs (30) on the same logic board.

6. The apparatus as set forth in anyone of claims 1 to 5, wherein
the FPGAs (30) are distributively disposed in a plurality of logic boards (26), and
each of the trace memory units (36) is disposed on the same logic board (26) with the coupled FPGA (30).

7. The apparatus as set forth in claim 6, wherein the apparatus further comprises a plurality of address counters correspondingly disposed on the logic boards (26) and coupled to the trace memory units (36) of the same logic board (26) for locally generating addresses for the corresponding local trace memory units in a manner coordinated with the outputting of the LE signal state values.

8. The apparatus as set forth in anyone of claims 6 or 7, wherein the trace data are stored into the trace memory units (36) in a wrap around manner.

9. The apparatus as set forth in anyone of claims 1 to 8, wherein the apparatus further comprises a system sync memory (152) for synchronously storing sync patterns to be used in post processing to reconstitute trace data of a trace session.

10. The apparatus as set forth in anyone of claims 1 to 9 including means (138) for generating a cross reference file (142) for cross referencing circuit elements of the circuit design to the relative memory locations where the signal state values of the LEs onto which the circuit elements are mapped are stored.

11. The apparatus as set forth in claim 10, wherein the cross reference file (142) comprises a plurality of cross reference records (146), each cross reference record having identification information of a circuit element (148), and one or more offset values (150, 152) with respect to a clock cycle into a particular block of memory locations where the signal state value of the LE onto which the circuit element is mapped is stored.

12. In an emulation system comprising a plurality of field programmable gate arrays (FPGAs) distributively disposed on one or more interconnected logic boards (26), each FPGA (30) being a single integrated circuit comprising a plurality of logic elements (LEs) (102) and an on-chip integrated output facility (108) for outputting as trace data signal state values of all LEs (102) on a clock cycle by clock cycle basis of an emulation clock, a method for performing fully visible tracing of an emulation, the method comprising
a) outputting signal state values for all logic elements (LEs) (102) of each field programmable gate array (FPGA) (30) of the emulation system used for emulating a circuit design;
b) capturing and storing the LE signal state values output as trace data into memory locations of a trace memory in a deterministic locality topology, under which the relative memory location within a block of memory locations used for storing a clock cycle of signal state values where the signal state value of a LE is stored is predeterminable,
wherein said trace memory is placed on-board close to said FPGAs (30) and one memory unit (36) is provided for each FPGA (30) and the trace data from said FPGAs are correspondingly stored in said memory units (36).

13. The method as set forth in claim 12, wherein each memory unit (36) is correspondingly coupled to a respective FPGA (30) on the same logic board (26).

14. The method as set forth in claim 13, wherein step (b) further comprises generating trace memory addresses on each logic board (26) locally and providing the locally generated trace memory addresses to the trace memory units (122) of the corresponding logic boards (26).

15. The method as set forth in anyone of claims 13 or 14, wherein step (b) further comprises storing the signal state value of a LE in the same relative offset location within a particular block of memory locations used for storing the LE state values output from a particular FPGA for a clock cycle.

16. The method as set forth in anyone of claims 13 to 15, wherein step (b) further comprises storing the trace data into said trace memory units (122) in a wrap around manner.

17. The method as set forth in claim 16, wherein the method further comprises the step of (c) storing a plurality of identical sync patterns in a sync memory (152) for a trace session, one sync pattern per clock cycle, and each sync pattern being stored synchronously at the same time the corresponding signal state values of a particular clock cycle are stored into the trace memory unit (122).

18. The method set forth in anyone of claims 12 to 17, comprising the step of generating a cross reference file (142) for cross referencing circuit elements of the circuit design to the relative memory locations where the signal state values of the LEs onto which the circuit elements are mapped are stored.

19. The method as set forth in claim 18, wherein generating the cross reference file (142) comprises generating a plurality of cross reference records (146), each cross reference record having identification information of a circuit element (148), and one or more offset values (150, 152) into a particular block of memory locations with respect to a clock cycle where the signal state value of the LE onto which the circuit element is mapped is stored.

## Patentansprüche

1. Vorrichtung mit
einer Mehrzahl benutzerprogrammierbarer Gate-Arrays (FPGAs) zum Emulieren mindestens einer Teilstruktur eines Schaltungsentwurfs, wobei die Mehrzahl von FPGAs (30) auf einer oder mehrerer miteinander verbundener Schaltungsplatinen (26) verteilt angeordnet ist, jedes FPGA (30) ein einziger integrierter Schaltkreis mit einer Mehrzahl logischer Elemente (LEs) (102) zum Realisieren von Schaltkreiselementen mindestens einer Teilstruktur des Schaltungsentwurfs und einer auf dem Chip integrierten Ausgabeeinrichtung (108) zum Ausgeben von Signalzustandswerten aller LEs (102) als Ablaufverfolgungsdaten unter Zugrundelegung von Taktzyklus für Taktzyklus eines Emulationstakts ist, und
einem mit den FPGAs (30) gekoppelten Ablaufverfolgungsspeicher mit einer Mehrzahl von Speicherplätzen zur Erfassung und Speicherung der ausgegebenen LE-Signalzustandswerte in einer deterministischen Ortstopologie, unter der der relative Speicherplatz innerhalb eines Taktzyklus von Ablaufverfolgungsdaten, an dem der Signalzustandswert eines Schaltkreiselements gespeichert ist, vorherbestimmbar ist,
wobei der Ablaufverfolgungsspeicher auf der Platine nahe bei den FPGAs (30) angeordnet ist und eine Mehrzahl von Speichereinheiten (36), jeweils eine für jedes FPGA (30), aufweist, sowie die Speichereinheiten (36) und die FPGAs (30) entsprechend miteinander gekoppelt sind.

2. Vorrichtung nach Anspruch 1, wobei jede Speichereinheit (36) Speicherplätze zur Speicherung von N-Taktzyklen von LE-Signalzustandswerten aufweist und der Signalzustandswert eines LE (102) in einer vorbestimmten festen Versetzung hinsichtlich jedes Taktzyklus in jedem zur Speicherung eines Taktzyklus von LE-Signalzustandswerten benutzten Block von Speicherplätzen gespeichert wird.

3. Vorrichtung nach einem der Ansprüche 1 oder 2, wobei die Vorrichtung ferner einen mit dem Ablaufverfolgungsspeicher (36) gekoppelten Adreßzähler (37) zur Erzeugung von Adressen für den Ablaufverfolgungsspeicher (36) in einer mit der Ausgabe der LE-Signalzustandswerte koordinierten Weise aufweist.

4. Vorrichtung nach einem der Ansprüche 1 bis 3, wobei
jedes FPGA (30) ferner einen auf dem Chip angeordneten Triggerschaltkreis (110) zum Ausgeben mindestens einer Triggereingabe ansprechend auf die Erfassung eines gespeicherten Datenmusters von LE-Signalzustandswerten aufweist, und
die Vorrichtung ferner mindestens einen mit den FPGAs (30) gekoppelten Summierschaltkreis (34) zur Erzeugung einer Partialsumme der mindestens einen Triggereingabe aufweist.

5. Vorrichtung nach Anspruch 4, wobei
die FPGAs (30) in einer Mehrzahl von Schaltungsplatinen (26) verteilt angeordnet sind,
der Summierschaltkreis (34) eine Mehrzahl von Partialsummenschaltkreisen (118) aufweist, die auf den Schaltungsplatinen (26) verteilt angeordnet sind und von denen jeweils mindestens einer mit den FPGAs (30) auf derselben Schaltungsplatine gekoppelt ist.

6. Vorrichtung nach einem der Ansprüche 1 bis 5, wobei
die FPGAs (30) in einer Mehrzahl von Schaltungsplatinen (26) verteilt angeordnet sind, und
jede der Ablaufverfolgungsspeichereinheiten (36) auf derselben Schaltungsplatine (26) mit dem gekoppelten FPGA (30) angeordnet ist.

7. Vorrichtung nach Anspruch 6, wobei die Vorrichtung ferner eine Mehrzahl von entsprechend auf den Schaltungsplatinen (26) angeordneten und mit den Ablaufverfolgungsspeichereinheiten (36) derselben Schaltungsplatine (26) gekoppelten Adreßzählern zum lokalen Erzeugen von Adressen für die entsprechenden lokalen Ablaufverfolgungsspeichereinheiten in einer mit der Ausgabe der LE-Signalzustandswerte koordinierten Weise aufweist.

8. Vorrichtung nach einem der Ansprüche 6 oder 7, wobei die Ablaufverfolgungsdaten in den Ablaufverfolgungsspeichereinheiten (36) in umlaufender Weise eingespeichert werden.

9. Vorrichtung nach einem der Ansprüche 1 bis 8, wobei die Vorrichtung ferner einen Systemsynchronspeicher (152) zum synchronen Speichern von in der Nachverarbeitung zur Rekonstruktion von Nachverfolgungsdaten einer Ablaufverfolgungssitzung zu verwendenden Synchronmustern aufweist.

10. Vorrichtung nach einem der Ansprüche 1 bis 9 mit einer Einrichtung (138) zum Erzeugen einer Querverweisdatei (142) zur Querverweisung von Schaltkreiselementen des Schaltungsentwurfs auf die relativen Speicherplätze, wo die Signalzustandswerte der LEs, auf die die Schaltkreiselemente abgebildet werden, gespeichert sind.

11. Vorrichtung nach Anspruch 10, wobei die Querverweisdatei (142) eine Mehrzahl von Querverweisaufzeichnungen (146) aufweist, deren jede eine Identifikationsinformation eines Schaltkreiselements (148) und einen oder mehrere Versetzungswerte (150, 152) bezüglich eines Taktzyklus in einem bestimmten Block von Speicherplätzen, wo der Signalzustandswert des LE, auf das das Schaltkreiselement abgebildet wird, gespeichert ist, aufweist.

12. In einem Emulationssystem mit einer Mehrzahl von auf einer oder mehreren miteinander verbundenen Schaltungsplatinen (26) verteilt angeordneten benutzerprogrammierbaren Gate-Arrays (FPGAs), wobei jedes FPGA (30) ein einziger integrierter Schaltkreis mit einer Mehrzahl logischer Elemente (LEs) (102) und einer auf dem Chip integrierten Ausgabeeinrichtung (108) zur Ausgabe von Signalzustandswerten aller LEs (102) als Ablaufverfolgungsdaten unter Zugrundelegung von Taktzyklus für Taktzyklus eines Emulationstakts ist, ein Verfahren zur Durchführung einer voll sichtbaren Ablaufverfolgung einer Emulation, wobei das Verfahren aufweist
a) Ausgeben von Signalzustandswerten für alle logischen Elemente (LEs) (102) jedes benutzerprogrammierbaren Gate-Arrays (FPGA) (30) des zum Emulieren eines Schaltungsentwurfs verwendeten Emulationssystems,
b) Erfassen und Speichern der ausgegebenen LE-Signalzustandswerte als Ablaufverfolgungsdaten in Speicherplätze eines Ablaufverfolgungsspeichers in einer deterministischen Ortstopologie, unter der der relative Speicherplatz innerhalb eines zur Speicherung eines Taktzyklus von Signalzustandswerten verwendeten Blocks von Speicherplätzen, wo der Signalzustand eines LE gespeichert ist, vorbestimmbar ist,
wobei der Ablaufverfolgungsspeicher auf der Platine nahe den FPGAs (30) angeordnet ist und für jedes FPGA (30) eine Speichereinheit (36) vorgesehen ist und die Ablaufverfolgungsdaten aus den FPGAs in den Speichereinheiten (36) entsprechend gespeichert werden.

13. Verfahren nach Anspruch 12, wobei jede Speichereinheit (36) entsprechend mit einem jeweiligen FPGA (30) auf derselben Schaltungsplatine (26) gekoppelt ist.

14. Verfahren nach Anspruch 13, wobei es Schritt (b) ferner umfaßt, die Ablaufverfolgungsspeicheradressen auf jeder Schaltungsplatine (26) lokal zu erzeugen und die lokal erzeugten Ablaufverfolgungsspeicheradressen an die Ablaufverfolgungsspeichereinheiten (122) der entsprechenden Schaltungsplatinen (26) zu liefern.

15. Verfahren nach einem der Ansprüche 13 oder 14, wobei es Schritt (b) ferner umfaßt, den Signalzustandswert eines LE in derselben relativen Versetzungsposition innerhalb eines zur Speicherung der von einem bestimmten FPGA für einen Taktzyklus ausgegebenen LE-Zustandswerte verwendeten bestimmten Blocks von Speicherplätzen zu speichern.

16. Verfahren nach einem der Ansprüche 13 bis 15, wobei es Schritt (b) ferner umfaßt, die Ablaufverfolgungsdaten in die Ablaufverfolgungsspeichereinheiten (122) in umlaufender Weise einzuspeichern.

17. Verfahren nach Anspruch 16, wobei das Verfahren ferner den Schritt umfaßt (c) Speichern einer Mehrzahl identischer Synchronmuster in einem Synchronspeicher (152) für eine Ablaufverfolgungssitzung, ein Synchronmuster pro Taktzyklus, und wobei jedes Synchronmuster synchron zur selben Zeit gespeichert wird, zu der die entsprechenden Signalzustandswerte eines bestimmten Taktzyklus in die Ablaufverfolgungsspeichereinheit (122) eingespeichert werden.

18. Verfahren nach einem der Ansprüche 12 bis 17 mit dem Schritt des Erzeugens einer Querverweisungsdatei (142) zur Querverweisung von Schaltkreiselementen des Schaltungsentwurfs auf die relativen Speicherplätze, wo die Signalzustandswerte der LEs, auf die die Schaltkreiselemente abgebildet werden, gespeichert sind.

19. Verfahren nach Anspruch 18, wobei das Erzeugen der Querverweisdatei (142) die Erzeugung einer Mehrzahl von Querverweisaufzeichnungen (146) umfaßt, deren jede eine Identifikationsinformation eines Schaltkreiselements (148) und einen oder mehrere Versetzungswerte (150, 152) bezüglich eines Taktzyklus in einem bestimmten Block von Speicherplätzen, wo der Signalzustandswert des LE, auf das das Schaltkreiselement abgebildet wird, gespeichert ist, aufweist.

## Revendications

1. Dispositif comprenant :
une pluralité de circuits diffusés programmables par l'utilisateur (FPGA) pour émuler au moins un sous-ensemble d'une conception de circuit, ladite pluralité de FPGA (30) étant disposés de manière répartie sur une ou plusieurs cartes logiques interconnectées (26), chaque FPGA (30) étant un simple circuit intégré comprenant une pluralité d'éléments logiques (LE) (102) pour réaliser des éléments de circuit de l'au moins un sous-ensemble de la conception de circuit et une disposition de sortie intégrée sur la puce (108) pour fournir en sortie en tant que signal de données de traçage, les valeurs d'état de tous les LE (102), cycle d'horloge par cycle d'horloge d'une horloge d'émulation ; et
une mémoire de traçage couplée aux FPGA (30) comprenant une pluralité d'emplacements mémoire pour saisir et mémoriser les valeurs d'état des signaux de LE fournis en sortie selon une topologie de localisation déterministe, selon laquelle l'emplacement mémoire relatif dans un cycle d'horloge de données de traçage où la valeur d'état de signal d'un élément de circuit est mémorisé, peut être prédéterminé,
dans lequel ladite mémoire de traçage est placée sur la carte près desdits FPGA (30) et comprend une pluralité de modules de mémoire (36), un pour chaque FPGA (30), lesdits modules de mémoire (36) et lesdits FPGA (30) étant couplés de façon correspondante entre eux.

2. Dispositif selon la revendication 1, dans lequel chaque module de mémoire (36) comprend des emplacements mémoire pour mémoriser N cycles d'horloge des valeurs d'état des signaux de LE et la valeur d'état de signal d'un LE (102) est mémorisée selon un décalage fixe prédéterminé par rapport à chaque cycle d'horloge dans chaque bloc des emplacements mémoire utilisés pour mémoriser un cycle d'horloge des valeurs d'état des signaux de LE.

3. Dispositif selon l'une quelconque des revendications 1 ou 2, dans lequel le dispositif comprend en outre un compteur d'adresses (37) couplé à la mémoire de traçage (36) pour produire des adresses pour la mémoire de traçage (36) d'une manière coordonnée avec la fourniture en sortie des valeurs d'état des signaux de LE.

4. Dispositif selon l'une quelconque des revendications 1 à 3, dans lequel
chaque FPGA (30) comprend en outre un circuit de déclenchement sur la puce (110) pour fournir en sortie au moins une entrée de déclenchement en réponse à la détection d'un motif de données mémorisé des valeurs d'état des signaux de LE ; et
le dispositif comprend en outre au moins un circuit de sommation (34) couplé aux FPGA (30) pour produire une somme partielle de l'au moins une entrée de déclenchement.

5. Dispositif selon la revendication 4, dans lequel
les FPGA (30) sont disposés de manière répartie dans une pluralité de cartes logiques (26),
le circuit de sommation (34) comprend une pluralité d'au moins un circuit de sommation partielle (118) disposés de manière répartie sur les cartes logiques (26) et couplés aux FPGA (30) sur la même carte logique.

6. Dispositif selon l'une quelconque des revendications 1 à 5, dans lequel
les FPGA (30) sont disposés de manière répartie dans une pluralité de cartes logiques (26), et
chacun des modules de mémoire de traçage (36) est disposé sur la même carte logique (26) avec le FPGA couplé (30) .

7. Dispositif selon la revendication 6, dans lequel le dispositif comprend en outre une pluralité de compteurs d'adresses disposés de façon correspondante sur les cartes logiques (26) et couplés aux modules de mémoire de traçage (36) de la même carte logique (26) pour produire localement les adresses pour les modules de mémoire de traçage locaux correspondants d'une manière coordonnée avec la fourniture en sortie des valeurs d'état des signaux de LE.

8. Dispositif selon l'une quelconque des revendications 6 ou 7, dans lequel les données de traçage sont mémorisées dans les modules de mémoire de traçage (36) d'une manière rebouclée.

9. Dispositif selon l'une quelconque des revendications 1 à 8, dans lequel le dispositif comprend en outre une mémoire de synchronisation de système (152) pour mémoriser de façon synchrone les motifs de synchronisation destinés à être utilisés dans un traitement ultérieur pour reconstituer les données de traçage d'une session de traçage.

10. Dispositif selon l'une quelconque des revendications 1 à 9, comportant un moyen (138) pour produire un fichier de références croisées (142) pour effectuer une référence croisée des éléments de circuit de la conception de circuit sur les emplacements mémoire relatifs où sont mémorisées les valeurs d'état de signal des LE sur lesquels les éléments de circuits sont mappés.

11. Dispositif selon la revendication 10, dans lequel le fichier de références croisées (142) comprend une pluralité d'enregistrements de références croisées (146), chaque enregistrement de référence croisée comportant des informations d'identification d'un élément de circuit (148) et une ou plusieurs valeurs de décalage (150, 152) par rapport à un cycle d'horloge dans un bloc d'emplacement mémoire particulier où est mémorisée la valeur d'état de signal du LE sur lequel l'élément de circuit est mappé.

12. Dans un système d'émulation, comprenant une pluralité de circuits diffusés programmables par l'utilisateur (FPGA) disposés de manière répartie sur une ou plusieurs cartes logiques interconnectées (26), chaque FPGA (30) étant un simple circuit intégré comprenant une pluralité d'éléments logiques (LE) (102) et une disposition de sortie intégrée sur la puce (108) pour fournir en sortie en tant que signal de données de traçage, les valeurs d'état de tous les LE (102), cycle d'horloge par cycle d'horloge d'une horloge d'émulation, procédé pour réaliser un traçage complètement visible d'une émulation, le procédé comprenant
a) la fourniture en sortie de valeurs d'état de signal pour tous les éléments logiques (LE) (102) de chaque circuit diffusé programmable par l'utilisateur (FPGA) (30) du système d'émulation utilisé pour émuler une conception de circuit ;
b) la saisie et la mémorisation des valeurs d'état des signaux de LE fournis en sortie en tant que données de traçage aux emplacements mémoire d'une mémoire de traçage selon une topologie de localisation déterministe, selon laquelle l'emplacement mémoire relatif dans bloc d'emplacements mémoire utilisé pour mémoriser un cycle d'horloge de données de traçage où est mémorisée la valeur d'état de signal d'un LE, peut être prédéterminé,
dans lequel ladite mémoire de traçage est placée sur la carte près desdits FPGA (30) et un module de mémoire (36) est prévu pour chaque FPGA (30), et les données de traçage provenant desdits FPGA sont mémorisées de façon correspondante dans lesdits modules de mémoire (36).

13. Procédé selon la revendication 12, dans lequel chaque module de mémoire (36) est couplé de façon correspondante à un FPGA respectif (30) sur la même carte logique (26).

14. Procédé selon la revendication 13, dans lequel l'étape (b) comprend en outre la production d'adresses de mémoire de traçage sur chaque carte logique (26) localement et la fourniture des adresses de mémoire de traçage produites localement aux modules de mémoire de traçage (122) des cartes logiques correspondantes (26).

15. Procédé selon l'une quelconque des revendications 13 ou 14, dans lequel l'étape (b) comprend en outre la mémorisation de la valeur d'état de signal d'un LE avec le même emplacement de décalage relatif dans un bloc d'emplacement mémoire particulier utilisé pour mémoriser les valeurs d'état des LE fournies en sortie par un FPGA particulier pour un cycle d'horloge.

16. Procédé selon l'une quelconque des revendications 13 à 15, dans lequel l'étape (b) comprend en outre la mémorisation des données de traçage dans lesdits modules de mémoire de traçage (122) d'une manière rebouclée.

17. Procédé selon la revendication 16, dans lequel le procédé comprend en outre l'étape (c) de mémorisation d'une pluralité de motifs de synchronisation identiques dans une mémoire de synchronisation (152) pour une session de traçage, un motif de synchronisation par cycle d'horloge et chaque motif de synchronisation étant mémorisé de façon synchrone en même temps que les valeurs d'état de signal correspondantes d'un cycle d'horloge particulier sont mémorisées dans le module de mémoire de traçage (122).

18. Procédé selon l'une quelconque des revendications 12 à 17, comprenant l'étape de production d'un fichier de références croisées (142) pour effectuer la référence croisée d'éléments de circuit de la conception de circuit sur les emplacements mémoire relatifs où sont mémorisées les valeurs d'état des LE sur lesquels les éléments de circuits sont mappés.

19. Procédé selon la revendication 18, dans lequel la production du fichier de références croisées (142) comprend la production d'une pluralité d'enregistrements de références croisées (146), chaque enregistrement de référence croisée comportant des informations d'identification d'un élément de circuit (148) et une ou plusieurs valeurs de décalage (150, 152) dans un bloc d'emplacement mémoire particulier par rapport à un cycle d'horloge où est mémorisée la valeur d'état de signal du LE sur lequel l'élément de circuit est mappé.
